**Europäisches Patentamt**

**European Patent Office**

**Office européen des brevets**

(19)

(11) Veröffentlichungsnummer: **0 066 836**
**B1**

(12) # EUROPÄISCHE PATENTSCHRIFT

(45) Veröffentlichungstag der Patentschrift:
**07.01.88**

(51) Int. Cl.⁴: **H 01 L 23/54**

(21) Anmeldenummer: **82104795.8**

(22) Anmeldetag: **01.06.82**

---

(54) Verfahren zur Kennzeichnung von Halbleiterchips und kennzeichenbarer Halbleiterchip.

---

(30) Priorität: **10.06.81 DE 3122984**

(43) Veröffentlichungstag der Anmeldung:
**15.12.82 Patentblatt 82/50**

(45) Bekanntmachung des Hinweises auf die Patenterteilung:
**07.01.88 Patentblatt 88/1**

(84) Benannte Vertragsstaaten:
**AT DE FR GB**

(56) Entgegenhaltungen:
**DE - A - 1 439 601
DE - A - 1 902 369
FR - A - 2 348 576**

**IEEE JOURNAL OF SOLID-STATE CIRCUITS, Band
SC-11, No.4, August 1976, New York (US); J.C.NORTH et
al.: "Laser-coding of bipolar read-only-memories",
Seiten 500-505**

(73) Patentinhaber: **Siemens Aktiengesellschaft Berlin und
München, Wittelsbacherplatz 2, D-8000 München 2 (DE)**

(72) Erfinder: **Schindlbeck, Günter, Dipl.-Ing.,
Habichtstrasse 1 a, D-8000 München 82 (DE)**

---

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Kennzeichnung von Halbleiterchips bezüglich mindestens eines bestimmten Merkmals.

Entsprechende Verfahren werden zur Kennzeichnung von Halbleiterchips angewandt, die in grosser Zahl aus einer Halbleiterscheibe (wafer) hergestellt werden, nach Abschluss der Herstellungsprozesse geprüft und gemäss dem Prüfergebnis entsprechend vorgegebenen Qualitätsmerkmalen oder vorgegebenen Verwendungszwecken gekennzeichnet werden. So ist es beispielsweise üblich, integrierte Schaltkreise, wie z.B. Halbleiterspeicher, noch vor dem Zerteilen der Halbleiterscheiben durch Anlegen von Messspitzen an auf der Chipoberfläche angeordneten Kontaktflächen mittels eines Testers zu prüfen und je nach Prüfresultat auf dem Bereich der Chipoberfläche, der keine Kontaktflächen aufweist, mit kleinen Tintenflecken zu versehen. Dieser Vorgang wird auch als «Inken» bezeichnet. Die Tintenflecke können unterschiedliche Farben aufweisen, so dass z.B. ein nicht geinkter Chip als der Qualitätsstufe 1 zugehörig, ein mit roter Tinte geinkter Chip als der Qualitätsstufe 2 zugehörig und ein mit blauer Tinte geinkter Chip als Ausschuss kennzeichenbar sind.

Solche mehrfarbigen Inkverfahren haben den Nachteil, dass Tinte auf der Chipoberfläche, insbesondere im aktiven Bereich, ein Zuverlässigkeitsrisiko darstellt. Durch Ausgasen der Tinte können ferner Probleme bei der Chipmontage auftreten. Weiterhin treten gelegentlich bei Abnehmern von geinkten Systemen Bedenken auf, da mit solchen Tintenflecken versehene Chips leicht als zweitrangig eingestuft werden können.

Ein anderes Kennzeichnungsverfahren sieht eine Hardware-Scheibenkarte vor, die den zu prüfenden Chips auf der Halbleiterscheibe entsprechend gerastert ist. Entsprechend der Funktionsfähigkeit der einzelnen Chips können einzelne Raster ausgestanzt werden, so dass ein topographisches Bild der Halbleiterscheibe entsteht. Bei diesem Verfahren ist jedoch die Übertragung der Informationen der Hardware-Scheibenkarten bei der Chipmontage schwierig und aufwendig, ferner besteht die Gefahr von Ausbeuteverlusten. Anstelle der Hardware-Scheibenkarte ist es auch möglich, die entsprechenden Informationen auf eine Software-Scheibenkarte, beispielsweise auf ein Datenband, zu bringen und diese Software-Scheibenkarte zur Montagesteuerung zu verwenden. Der hierbei erforderliche hohe Automatisierungsgrad verursacht jedoch hohe Kosten, eine Verwechslungsgefahr der Chips bzw. der Scheiben ist trozdem nicht ausgeschlossen.

Aufgabe der vorliegenden Erfindung ist es, hier Abhilfe zu schaffen und ein Verfahren zur Kennzeichnung von Halbleiterchips vorzusehen, bei dem der einzelne Chip unverwechselbar gekennzeichnet ist und bei dem ein zusätzliches Zuverlässigkeitsrisiko und eine Minderung des Verkaufswertes nicht auftritt, sowie einen zur Durchführung dieses Verfahrens geeigneten Halbleiterchip zu schaffen.

Neuer Beschreibungsteil

Diese Aufgabe wird bei einem Verfahren der eingangs genannten Art erfindungsgemäss durch die kennzeichnenden Merkmale des Patentanspruches 1 sowie bei einem entsprechenden Halbleiterchip durch die kennzeichnenden Merkmale des Patentanspruches 5 gelöst.

Vorteilhafte Aus- und Weiterbildung sind in Unteransprüchen gekennzeichnet.

Die Erfindung ermöglicht, ohne Aufbringen eines zusätzlichen Stoffes auf die Chipoberfläche die Halbleiterchips zu kennzeichnen und die Kennzeichnung so zu gestalten, dass sie von einem Unbeteiligten nicht erkannt werden kann. Als zum Zwecke des Markierens vorgesehene Kontaktflächen und Leiterbahnen werden vorzugsweise üblicherweise metallisierte Flächen verwendet, da solche Flächen auch anderweitig bei der Herstellung von integrierten Schaltungen vorgesehen sind und somit ohne nennenswerte Mehrkosten herstellbar sind.

Aus der DE-A 19 02 369 ist ein Verfahren bekannt, bei dem einzelne Schaltkreise einer Gruppe von Schaltkreisen, die eine gleiche Funktion aufweisen, die auf einem gemeinsamen Substrat angeordnet sind und die parallel miteinander mittels Metallisierung vebunden sind, geprüft werden. Wird beim Prüfen das Vorliegen eines vorgegebenen Kriteriums erkannt, so wird die Prüfung abgebrochen und es wird die metallische Verbindung der geprüften Schaltkreise mit den ungeprüften Schaltkreisen aufgetrennt. Die metallische Verbindung betrifft elektrisch funktionelle Elemente der Schaltkreise wie z.B. Widerstände oder Leitungen für Versorgungsspannungen.

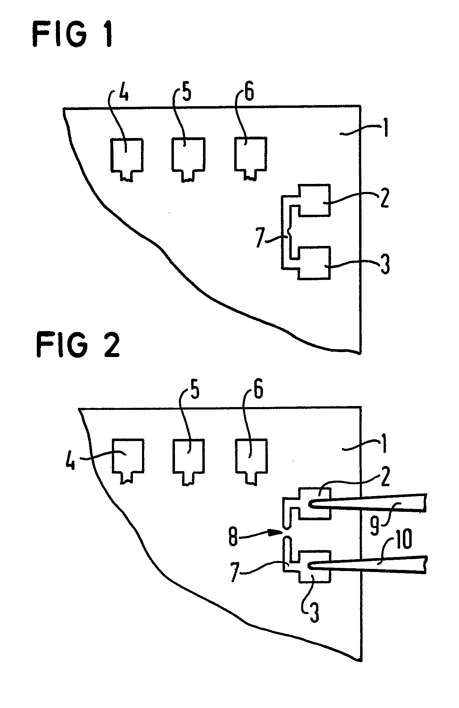

Die Erfindung wird im folgenden anhand der Figuren näher erläutert. Die Figuren 1 und 2 zeigen einen Ausschnitt aus der vergrösserten Oberfläche eines Halbleiterchips in unterschiedlichen Verfahrenszuständen.

Der in Fig. 1 gezeigte Ausschnitt aus der Oberfläche eines Halbleiterchips 1 zeigt drei Kontaktflächen 4, 5, 6, die am Rande des Halbleiterchips 1 angeordnet sind und zur Herstellung von elektrischen Verbindungen zwischen den mit ihnen verbundenen, auf dem Chip 1 befindlichen, in der Figur nicht gezeigten Halbleiterstrukturen und den Aussenanschlüssen des Chipgehäuses mittels Drähten kontaktierbar sind. Ferner sind, ebenfalls am Rande des Chips 1 zwei weitere Kontaktflächen 2, 3 angeordnet, die mittels einer Leiterbahn 7 verbunden sind. Die Kontaktflächen 2 bis 6 und die Leiterbahn 7 können im gleichen technologischen Herstellungsschritt gefertigt werden und beispielsweise aus Aluminium bestehen. Die Kontaktflächen 2 und 3 müssen keinen Anschluss zu einer auf dem Chip 1 befindlichen Halbleiterstruktur aufweisen.

Zur Kennzeichnung des Chips 1 bezüglich eines bestimmten Merkmales wird nun – wie in der Fig. 2 dargestellt – die zum Zwecke des Markierens vorgesehene, die Kontaktflächen 2 und 3 verbindende Leiterbahn 7 z.B. an der Stelle 8 durchtrennt. Dies kann z.B. in der Weise geschehen, dass eine durchtrennte Leiterbahn 7 einen Ausschuss-Chip kennzeichnet, während eine intakte Leiterbahn 7 einen funktionsfähigen Chip kennzeichnet. Vor oder während der Montage des Chips 1 in ein Gehäuse kann dann beispielsweise durch Anlegen von Kontaktspitzen an die Kontaktflächen 2 und 3 elektronisch festgestellt werden, ob der zu montierende Chip ein Ausschuss-Chip oder ein funktionierender Chip ist. Soll nicht nur zwischen funktionsfähig und nicht-funktionsfähig unterschieden werden, sondern sollen mehrere Qualitätsstufen unterschieden werden, so können entsprechend viele Kontaktstellenpaare, die mit Leiterbahnen verbunden sind, vorgesehen werden. Es ist somit ohne grossen technischen Aufwand möglich, Qualitätsmerkmale bzw. Einsatzoder Verwendungszweck eines Chip automatisch festzustellen, und somit Fehlerquellen weitgehend auszuschliessen.

Das Durchtrennen der die Kontaktflächen 2 und 3 verbindenden Leiterbahn 7 kann beispielsweise durch einen über Prüfspitzen 9 und 10 anlegbaren Stromstoss, der ein Verdampfen der Leiterbahn 7 an ihrer engsten Stelle zur Folge hat, erfolgen. Dies ist in einfacher Weise ohne zusätzlichen apparativen Aufwand möglich, da Halbleiterchips bei ihrer Prüfung durch Testgeräte mit diesen Testgeräten bereits über die mit Prüfspitzen kontaktierten Kontaktflächen 4, 5, 6 verbunden sind.

Ein weiteres Verfahren zur Durchtrennung der Leiterbahn 7 ist das Durchtrennen der Leiterbahn 7 mittels eines Laserstrahls. Es ist auch möglich, die Leiterbahn 7 mittels eines Ultraschall-Cutters, d.h. durch mechanische Reibung, zu trennen. Die Abmessungen der Kontaktflächen 2 und 3 und der Leiterbahn 7 können den für Leiterbahnen und Kontaktflächen auf dem übrigen Chip 1 entsprechenden Grössen entsprechen. Ein Zuverlässigkeitsrisiko beim Durchtrennen der Leiterbahn 7 für die Funktion des Chips 1 ist durch die Anordnung der Leiterbahn 7 am Chiprand auszuschliessen.

## Patentansprüche

1. Verfahren zur Kennzeichnung von Halbleiterchips (1) bezüglich mindestens eines bestimmten Merkmals, dadurch gekennzeichnet, dass zur elektronisch erfassbaren Kennzeichnung mindestens eine Leiterbahn (7), die zwei auf der Chipoberfläche angeordnete Kontaktflächen (2, 3), welche keinen Anschluss zu einer auf dem Halbleiterchip (1) befindlichen Halbleiterstruktur aufweisen, miteinander verbindet, in Abhängigkeit vom zu kennzeichnenden Merkmal durchtrennt wird.

2. Verfahren nach Anspruch 1, dadurch gekennzeichnet, dass die Leiterbahn (7) mittels eines Stromstosses durchtrennt wird.

3. Verfahren nach Anspruch 1, dadurch gekennzeichnet, dass die Leiterbahn mittels Ultraschall durchtrennt wird.

4. Verfahren nach Anspruch 1, dadurch gekennzeichnet, dass die Leiterbahn (7) mittels eines Laserstrahls durchtrennt wird.

5. Halbleiterchip zur Durchführung des Verfahrens nach einem der Ansprüche 1 bis 4, dadurch gekennzeichnet, dass mindestens eine Leiterbahn (7) vorgesehen ist, die zwei Kontaktflächen (2, 3), die auf der Chipoberfläche angeordnet sind und die keinen Anschluss zu einer auf dem Halbleiterchip (1) befindlichen Halbleiterstruktur aufweisen, miteinander verbindet, und die in Abhängigkeit vom Vorliegen eines bestimmten Merkmals durchtrennbar ist.

## Claims

1. A process for marking semiconductor chips (1) in respect of at least one specific characteristic, characterised in that in order to provide an electronically detectable marking, at least one conductor path (7) connecting two contact surfaces (2, 3) arranged on the chip surface and which have no connection to a semiconductor structure arranged on the semiconductor chip (1), is severed in dependence upon the characteristic which is to be marked .

2. A process as claimed in Claim 1, characterised in that the conductor path (7) is divided by means of a current surge.

3. A process as claimed in Claim 1, characterised in that the conductor path is divided ultrasonically.

4. A process as claimded in Claim 1, characterised in that the conductor path (7) is divided by means of a laser beam.

5. A semiconductor chip for carrying out the process claimed in one of Claims 1 to 4, characterised in that at least one conductor path (7) is provided which connects two contact surfaces (2, 3), arranged on the chip surface and which have no connection to a semiconductor structure arranged on the semiconductor chip (1), and which can be severed in dependence upon the existence of a specific characteristic.

## Revendications

1. Procédé pour le marquage de puces semiconductrices (1) du point de vue d'au moins une caractéristique déterminée, caractérisé par le fait que pour la saisie électronique du marquage on coupe, en fonction de la caractéristique à odentifier, au moins une piste conductrice (7) qui relie entre elles deux surfaces de contact (2, 3) disposées sur la surface de la puce et qui ne comportent aucune liaison électrique avec une structure semiconductrice qui se trouve la pace semiconductrice (1).

2. Procédé selon la revendication 1, caractérisé par le fait que la piste semiconductrice (7) est coupée à l'aide d'une impulsion de courant.

3. Procédé selon la revendication 1, caractérisé par le fait que la piste conductrice est coupée par ultrasons.

4. Procédé selon la revendication 1, caractérisé par le fait que la piste conductrice est coupée à l'aide d'un rayon laser.

5. Puce semiconductrice pour la mise en œuvre du procédé selon l'une des revendications 1 à 4, caractérisée par le fait qu'il est prévu au moins une piste conductrice (7) qui relie entre elles deux surfaces de contact (2, 3) qui sont disposée sur la surface de la puce et qui ne comportent aucune liaison électrique avec une structure semiconductrice se trouvant sur la puce semiconductrice (1), et qui est susceptible d'être coupée en fonction de la présence d'une caractéristique déterminée.

## FIG 1

## FIG 2